Europäisches Patentamt

European Patent Office

Office européen des brevets

(11) Publication number: **0 157 376**
A2

# (12) EUROPEAN PATENT APPLICATION

(21) Application number: 85103777.0

(51) Int. Cl.⁴: **H 01 L 27/14, H 01 L 29/78**

(22) Date of filing: 28.03.85

(30) Priority: 02.04.84 US 595807

(43) Date of publication of application: 09.10.85
Bulletin 85/41

(84) Designated Contracting States: **DE FR GB IT**

(71) Applicant: HONEYWELL INC., Honeywell Plaza,
Minneapolis Minnesota 55408 (US)

(72) Inventor: Foss, Norman A., 4 West Shore Road, North
Oaks Minnesota 55110 (US)

(74) Representative: Rentzsch, Heinz et al, Honeywell
Europe S.A. Holding KG Patent- und Lizenzabteilung
Kaiserleistrasse 55, D-6050 Offenbach am Main (DE)

(54) Charge transfer device and method.

(57) A CCD input apparatus provides a fixed surface potential level (66) between a source (56) of charge carriers (64) and a transfer gate (57) which directs the charge carriers (64) into a CCD shift register (46 + 48). The charge carriers (64) are accumulated in a substrate (54) during a time interval (typically the frame time) and the transfer pulse is applied once per each such time interval to the transfer gate (52). The fixed channel potential level (66) isolates the charge carrier source (56) from electrical noise due to variations of the potential on the transfer gate (52). The CCD shift register is clocked such that at least three clocking signals are applied to each gate of the shift register during each charge accumulation time interval.

HONEYWELL INC.

Honeywell Plaza

Minneapolis, Minn. USA

0157376

March 27, 1985

A4110143EP

HR/de

## CHARGE TRANSFER DEVICE AND METHOD

The present invention relates to means and methods of reducing noise levels in charge transfer device (CTD) imagers and particularly in charged coupled device (CCD) area imagers employing Schottky barrier infrared focal planes.

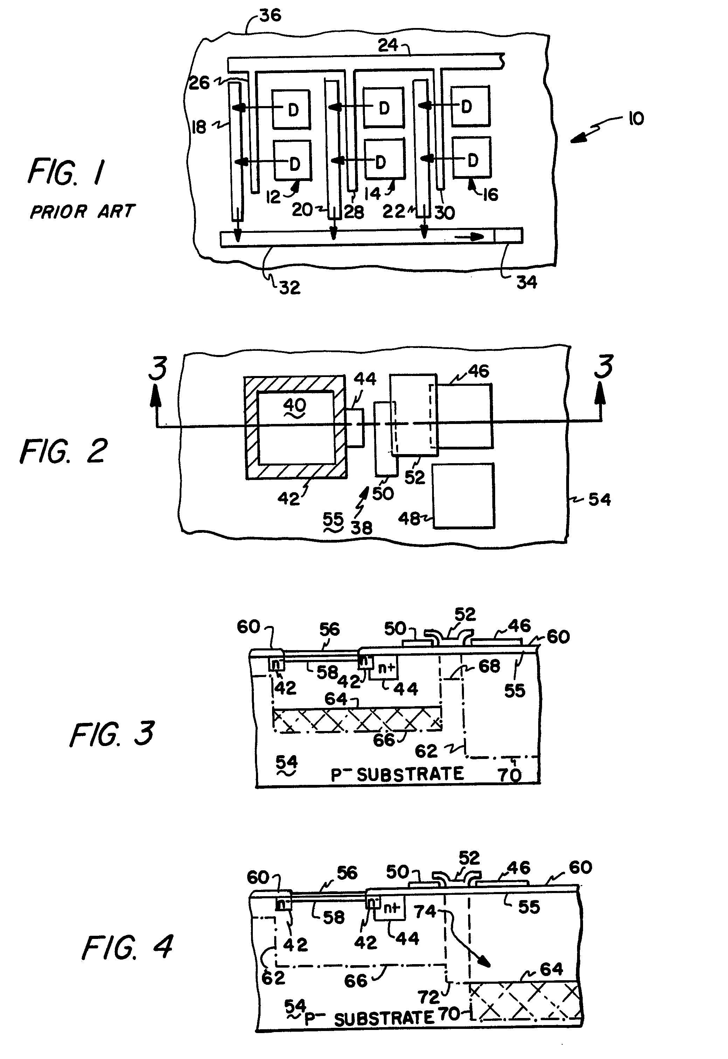

The basic interline CCD area imager 10 is known and shown in Figure 1. Therein columns 12, 14 and 16 of photodetectors (each D represents a separate detector) are alternated in parallel with non-illuminated CCD shift registers 18, 20 and 22. A transfer gate 24 includes portions 26, 28 and 30 positioned between photodetectors D and shift registers 18, 20 and 22. A horizontal shift register 32 multiplexes charge packets from the shift registers 18, 20 and 22 to provide image lines to output 34. The above structure overlies or is implanted in the surface of a substrate 36 which is typically Si.

In operation, charge carriers are accumulated in substrate 36 underneath each detector D in relation to the exposure time and intensity of the detectors D. At fixed intervals (i.e., typically the frame time) transfer gate 24 is pulsed to transfer substantially all the accumulated charge carriers from beneath detectors D to the associated shift register. Clocking signals are uniformly applied to the shift registers 18, 20 and 22 along horizontal lines. This insures that line by line image data is moved toward horizontal shift register 32. Shift register 32 is normally adapted to sequentially pass charge packets to output 34.

The clocking signals are not necessarily related to the frame time. Typically multiple clock periods will occur during one frame cycle.

After the transfer of the charge carriers from beneath detectors D, all the detectors D (typically diodes) are reset to the same voltage at the end of each frame (i.e., the vidicon mode).

Schottky barrier focal plane arrays as well as interline CCD visible imagers are capable of operating at noise levels down to the $KTC_D$ reset noise of the detector (i.e., K is Boltzman's constant, T is temperature in Kelvin and $C_D$ is the capacitance of the detector). This $KTC_D$ noise is due to the uncertainty in charging up the detector D to a voltage $V_D$. These noise levels are typically on the order of several hundred microvolts per $\sqrt{Hz}$ . However, in designs which have already been implemented in focal plane arrays, noise levels have been measured to be significantly higher than the calculated $KTC_D$ value.

One significant source of excess noise is due to voltage variations on the transfer gate pulse. Since it is very difficult to have a pulse generator operate at the low noise level needed, a technique which establishes a low noise gate voltage which is independent of transfer pulse generator noise is highly desirable. This object is accomplished by the device as characterized in claim 1 with further improvements and embodiments being described in the dependant claims.

The invention discloses an apparatus for effecting the transfer of charge carriers in a substrate from beneath a detector to a location in the substrate beneath one of a plurality of clocked gates, where the gates overlie part of the substrate and are adapted to further transfer the charge carriers between adjacent clocked gates in response to clocking signals. The charge carriers accumulate beneath the detector during selected time intervals (typically equal to the frame time) and each of the clocked gates is impressed with more than two clocking signals during such intervals. A transfer gate overlies a portion of the substrate and is positioned proximate one of the clocked gates. The transfer gate has a transfer signal impressed thereupon at most once during each selected time interval. A reset gate overlies a portion of the substrate and is

0157376

positioned between the detector and transfer gate. The reset gate has a substantially constant voltage impressed upon it.

The invention furthermore describes a method for isolating the detector from the inherent noise of the transfer signal pulse by providing a fixed channel potential between the potential well underneath the transfer gate and the potential well underneath the detector. The level of the fixed channel potential is preferrably selected to lie between the levels of the channel potentials beneath the transfer gate before the application of the transfer pulse and after the application of the transfer pulse. The fixed channel potential is conveniently provided by placing a reset gate between the transfer gate and the detector and impressing a substantially constant voltage on the reset gate. In the preferred embodiment, the reset gate also serves to reset the channel potential beneath the detector at the end of each frame time.

### BRIEF DESCRIPTION OF THE DRAWINGS

Figure 1 is a schematic of a prior art interline CCD imager.

Figure 2 is a plan view of a portion of a Schottky barrier focal plane array including the present invention.

Figure 3 is a cross sectional view of the apparatus of Figure 2 along line 3-3 with a channel potential diagram superimposed thereupon corresponding to a first time $T_1$.

Figure 4 is a cross sectional view of the apparatus of Figure 2 along line 3-3 with a channel potential diagram superimposed thereon corresponding to a second time $T_2$.

## DESCRIPTION OF THE PREFERRED EMBODIMENT

CCD 38 of Figure 2 includes a detector 40, guard ring 42, and $n^+$ diffusion 44, shift register gates 46 and 48, reset gate 50, transfer gate 52 and substrate 54 (having a principal surface 55).

Figures 3 and 4 illustrate further structure of device 38. Detector 40 is conveniently depicted as a Schottky barrier device including metallized portion 56 and silicide layer 58 (e.g., platinum silicide, palladium silicide or iridium silicide). Guard ring 42 and $n^+$ diffusion 44 serve to prevent surface leakage currents between layer 58 and surface 55. Insulating layer 60 (not shown in Figure 2 for convenience) is typically $SiO_2$.

In operation (see Figure 3) a channel potential profile (see dot /dash line 62) is provided at a first time $T_1$ by impressing various voltages upon gates 46, 50 and 52. For a surface CCD, the channel potential profile 62 is generally referred to as a surface potential profile, but channel potential and surface potential are used synonymously herein.

The channel potential beneath implant 58 is shown at $T_1$ to equal the channel potential beneath gate 50. This will be discussed further below with regard to the resetting of detector 40 after charge has been transferred from beneath it.

After $T_1$, detector 40 is exposed to electromagnetic energy which includes frequencies which cause charge carriers (see crosshatched area 64) to accumulate in the potential well 66 formed beneath detector 40 and gate 50. The electrical potential applied to gate 52 is selected so that for the period during which charge carriers are accumulated under detector 40 (e.g., the frame time) charge packet 64 will not rise above barrier 68.

Figure 3 shows an additional potential well 70 beneath gate 46. Well 70 is due to clocking signals impressed upon gate 46. These clocking signals are typically periodic with a frequency such that at least several cycles will occur during the time it takes for packet 64 to be generated (i.e., several cycles will occur during the frame time). Thus Figure 3 is intended to represent a condition where packet 64 is substantially formed and the clocking signal on gate 46 is high thus providing a deep well 70.

At time $T_2$ (see Figure 4) after packet 64 is formed, gate 52 is impressed with an electrical potential which eliminates barrier 68. For typical configurations this means that at $T_2$ gate 52 is impressed with an electrical potential transfer pulse of a larger electrical potential than that impressed on gate 52 at time $T_1$. Preferably, the transfer pulse is selected so that a well 72 is formed beneath gate 52 which is at least as deep as well 66 (ignoring packet 64).

With barrier 68 eliminated, packet 64 will flow as shown by arrow 74 into well 70. The duration of the transfer pulse is selected so that packet 64 has sufficient time to transfer to well 70. Figure 4 depicts packet 64 as being completely transferred to well 70 although those skilled in the art will recognize that some transfer inefficiency is inevitable. For normal operation well 70 will occur (due to the clocking signals impressed on gate 46) during the period of the transfer pulse.

At a later time $T_3$, the transfer pulse terminates and barrier 68 is restored. The voltage

-8-

profile 62 of Figure 3 again pertains and, of course, a new charge packet (not shown) begins to form beneath sensor 40. The clocking signals on gates 46 and 48 will move packet 64 from beneath gate 46 to beneath gate 48 as packet 64 begins to move along a CCD shift register which includes gates 46 and 48.

During the above process the voltage applied to gate 50 is a DC voltage selected to provide a channel potential beneath gate 50 which lies between the channel potential of barrier 68 and the channel potential of well 72. Typically this DC reset volage is 5 to 10 volts. The reset voltage further serves to reverse bias the diode/detector 40. It should not be selected to exceed the reverse breakdown voltage of diode/detector 40.

At time $T_3$ when barrier 68 is restored, the reset voltage of detector 40 is determined by gate 50 and not by transfer gate 52. This is because the channel potential beneath gate 40 will equilibrate with the channel potential beneath gate 50 as charge carriers beneath detector 40 which lie above the channel potential beneath gate 50, flow (as indicated by arrow 74) into the periodically formed wells 70 and 72. Therefore the reset voltage of detector 40 is independent of the noise on transfer gate 52.

-9-

The length of DC reset gate 50 can, for typical CCD image array dimensions, be relatively small (e.g., 4 microns). Thus gate 50 will not significantly change the fill factor of detector 40.

By using DC gate 50 to isolate detector 40 from noise due to transfer pulses, the performance range of both low light level visible CCD imagers and Schottky barrier infrared focal plane arrays is significantly extended over the range provided by the prior art.

Gates 46, 48, 50 and 52 can be metal or some suitably doped polysilicon depending on the particular application of device 38 or the desires of those utilizing it. A buried CCD implant (not shown) can be formed beneath gates 46 and 48 if these gates are to be part of a buried CCD. The clocking signals applied to gates 46 and 48 are preferrably periodic. However, the clocking signals could be generated in an irregular manner with the time between consecutive applications of a clocking signal to any particular gate of the shift registers varying, and the clocking signals themselves varying in shape and duration within such irregular intervals. The only limitation is that during the time interval in which charge carriers are accumulated (such intervals not necessarily being periodic) at least three clocking signals (e.g., high, low then high again) are applied to the shift register gate 46.

Further, transfer gate 52 can be alternately described as a means of providing a first channel potential level (e.g., barrier height 68) in substrate 54 beneath a fixed location on surface 55 when gate 52 has no transfer pulse applied thereto, and as a means for providing a second channel potential level (e.g., the depth of well 72) beneath such fixed location when a transfer pulse is applied to gate 52. Likewise, reset gate 50 can be alternately described as a means for providing a third channel potential level (e.g., the depth of well 66) beneath another location on surface 55, such other location lieing on a path on surface 55 between detector 40 and CCD shift register input gate 46. Also, CCD shift registers 18, 20 and 22 can be described as means for moving charge carriers within substrate 54.

The CCD input apparatus provides a fixed surface potential level 66 between a source 56 of charge carriers 64 and a transfer gate 57 which directs the charge carriers 64 into a CCD shift register 46 and 48. The charge carriers 64 are accumulated in a substrate 54 during a time interval (typically the frame time) and the transfer pulse is applied once per each such time interval to the transfer gate 52. The fixed channel potential level 66 isolates the charge carrier source 56 from electrical noise due to variations of the potential on the transfer gate 57. The CCD shift register is clocked such that at least three clocking signals are applied to each gate of the shift register during each charge accumulation time interval.

CLAIMS:

1. A device for effecting the transfer of charge carriers in a solid substrate (54) between a first location (beneath 56) and a second location (beneath 46), wherein the charge carriers (64) are accumulated in said first location, c h a r a c t e r i z e d b y

   a) means (52) for providing a first channel potential level (68) in said substrate beneath a third location (beneath 52) lieing on a path (e.g. line 3-3) between said first and second locations;

   b) means (52) for providing a second channel potential level (72) beneath said third location, whereat said second channel potential level (72) is lower than said first channel potential level (68); and

   c) means (50) for providing a constant third channel potential level (66) beneath a fourth location (beneath 50) lieing in said path between said first and third locations whereat said third channel potential level (66) is lower than said first channel level (68) but not lower than said second channel potential level (72).

2. A device according to claim 1 with the solid substrate (54) having a principal surface (55), c h a r a c - t e r i z e d   i n   t h a t   the channel potential levels (68,72,66) are provided beneath locations (56,46,52) situated on said surface.

3. A device  according to claim 1 or 2, c h a r a c - t e r i z e d   i n   t h a t   the first and second channel potential levels (68,72) are determined by a plurality of clocking signals and the second channel potential level (72) is at selected times

0157376

provided in place of the first channel potential level (68) wherein the intervals between said selected times each include at least three of said clocking signals, at least one of said clocking signals occurs while said second channel potential level (72) is provided and said second channel potential level (72) is lower than said first channel potential level (68).

4. A device according to one of the preceding claims wherein the first location is provided beneath a detector (56) c h a r a c t e r i z e d   b y
   d) a CTD shift register (46,48) on said substrate (54) wherein periodical clocking signals are applied to portions of said CTD shift register;
   e) a first gate (50) overlying a first portion of said substrate (54) between said detector (56) and said CTD shift register (46,48), and being adapted to have a substantially constant voltage applied thereto; and
   f) a second gate (52) overlying a second portion of said substrate between said first gate (50) and said CTD shift register (46,48), and being adapted to have a voltage pulse applied thereto at intervals which are at least twice the duration of the period of the clocking signals.

5. A device according to claim 4, c h a r a c t e r - i z e d   i n   t h a t   not other gate overlies said substrate (54) between said first (50) and second gates (52).

6. A device according to claim 5, c h a r a c t e r - i z e d   b y   an insulating layer (60) overlying part of the surface (55) of said substrate (54) wherein said first (50) and second (52) gates are in direct contact with said insulating layer (60).

7. A device according to claim 5 or 6, c h a r a c -
t e r i z e d    i n    t h a t    said detector (56)
is a Schottky barrier photodiode including a
silicide layer (58) on the surface (55) of said
substrate (54) selected from the group consisting
of platinum silicide, palladium silicide and
iridium silicide.

8. A device according to one of the preceding claims,
wherein the first location in said substrate (54)
lies beneath a detector (56) and the second location
in said substrate lies beneath one of a plurality of
clocked gates (46), c h a r a c t e r i z e d   i n   t h a t
    g)    said detector (56) and said clocked gates
(46) overlie separate areas of said substrate (54)
and each of said clocked gates is impressed with
more than two voltage clocking signals during a
predetermined time interval;
h) a transfer gate (52) overlying a first portion
    of said substrate, being positioned proximate one
    of said clocked gates (46), having a transfer
    voltage impressed thereupon at most once during
    said predetermined time interval and being
    adapted to transfer at least some of any of said
    charge carriers (64) in said substrate from the
    location  beneath said transfer gate (52) to a
    location beneath said one of said clocked gates
    (46) when said transfer voltage is impressed upon
    said transfer gate; and
i) a reset gate (50) overlying a second portion of
    said substrate, being positioned proximate said
    transfer gate (52) and proximate said detector (56),
    having a substantially constant voltage impressed
    thereupon during said predetermined time interval
    and being adapted to transfer at least some of any of said charge carriers (64) in said location beneath said detector (56) to said location beneath said transfer gate (52) when said transfer voltage is impressed upon said transfer gate.

9. A method for effecting the transfer of charge carriers (64) in a solid substrate (54) having a principal surface (55), said charge carriers (64) being transferred between beneath a first location (beneath 56) on said surface (55) and beneath a second location (beneath 46) on said surface, wherein said charge carriers (64) are accumulated in said substrate beneath said first location (beneath 56) and the channel potential (70) in said substrate beneath said second location is determined by a plurality of clocking signals, c h a r a c t e r i z e d   b y

j) providing a first channel potential level (68) in said substrate beneath a third location (beneath 52) on said surface, said third location lieing on a path (e.g. line 3-3) along said surface between said first (beneath 56) and second locations (beneath 46);

k) providing a second channel potential level (72) beneath said third location (beneath 52) in place of said first channel potential level (68) at selected times, wherein the intervals between said selected times each include at least three of said clocking signals, at least one of said clocking signals occurs while said second channel potential level (72) is provided and said second channel potential level (72) is lower than said first channel potential level (68); and

l) providing a constant third channel potential level (66) beneath a fourth location (beneath 50) on said surface (55), said fourth location lieing on said path (e.g. line 3-3) between said first (beneath 56) and third (beneath 46) locations and said third channel potential level (66) being lower than said first channel potential level (68) but not lower than said second channel potential level (72).

FIG. 1

PRIOR ART

FIG. 2

FIG. 3

FIG. 4